Europäisches Patentamt

European Patent Office  (11) Numéro de publication: **0 154 602**

Office européen des brevets  **A1**

(12) **DEMANDE DE BREVET EUROPEEN**

(21) Numéro de dépôt: 85810014.2

(51) Int. Cl.⁴: **H 01 R 23/68**

(22) Date de dépôt: **18.01.85**

(30) Priorité: **19.01.84 CH 234/84**

(43) Date de publication de la demande:
**11.09.85 Bulletin 85/37**

(84) Etats contractants désignés:
**IT**

(71) Demandeur: **BATTELLE MEMORIAL INSTITUTE**
**7 route de Drize**
**CH-1227 Carouge/Genève(CH)**

(72) Inventeur: **Mizzi, Francois**
**16, avenue des Gressets**
**FR-78170 La Celle Saint Cloud(CH)**

(72) Inventeur: **Grimaud, Jean-Jacques**
**2111 Bellview Drive**
**Palo Alto Ca. 94303(US)**

(74) Mandataire: **Dousse, Blasco et al,**
**7, route de Drize**
**CH-1227 Carouge/Genève(CH)**

(54) Connecteur électrique d'un module à circuit électronique.

(57) Ce connecteur est destiné à relier électriquement un module "fille" aux barres "bus" d'un système "mère".

Il comporte une pluralité de pistes conductrices (21) formées sur une face d'une feuille isolante souple (13) constituant le p.c. board d'un circuit électronique du module, l'autre face de cette feuille étant solidaire d'une lame-ressort (20) tendant à maintenir les pistes (21) en position naturellement distante des barres "bus" auxquelles elles doivent être reliées.

La mise en contact des pistes et des barres "bus" a lieu par déplacement d'un coulisseau (12) susceptible de faire prise sur la feuille (14) pendant une partie de sa course et de la faire fléchir, à l'encontre de la lame (20), suffisamment pour que les pistes de la feuille viennent toucher les barres "bus". L'interruption du contact s'effectue par un déplacement inverse du coulisseau.

*FIG. 3*

## CONNECTEUR ELECTRIQUE

Comme on le sait, les installations et appareils à fonctionnement électronique sont constitués aujourd'hui, dans leur quasi totalité, par assemblage d'une pluralité de cartes amovibles, et donc interchangeables, généralement formées par un circuit imprimé faisant support pour un ou plusieurs circuits électroniques, par exemple des circuits intégrés, branchés sur ce circuit, voire couplés entre eux par l'intermédiaire d'un tel circuit. A l'intérieur d'une même installation ou appareil, ces cartes sont couplées entre elles par l'intermédiaire d'un ensemble de barres "bus" auxquelles elles sont reliées galvaniquement par des systèmes de connecteurs aussi divers que nombreux, généralement de mise en oeuvre assez complexe, interdisant pratiquement à tout usager néophyte de procéder de lui-même au remplacement d'une carte par une autre. De plus, un tel remplacement ne peut généralement avoir lieu qu'en accédant au coeur même de l'installation ou appareil en question.

L'apparition des jeux électroniques et des mini-ordinateurs à usage domestique a conduit les constructeurs à prévoir la possibilité pour les usagers de procéder eux-mêmes à la substitution de certaines cartes portant des circuits donnés, concernant par exemple des programmes informatisés, sans devoir ni opérer à l'intérieur du boîtier de ces appareils ni faire usage d'outils particuliers. C'est ainsi qu'on a disposé ces cartes sous enveloppe rigide de protection, enfichable sur une partie du boîtier prévue à cet effet, les liaisons de nature électrique étant réalisées à l'aide de connecteurs appropriés dont l'architecture ne limite d'ailleurs pas leur emploi dans le contexte ci-dessus mais est également souvent valable pour assurer le branchement électrique de cartes électroniques traditionnelles, telles celles mentionnées précédemment.

Le but de la présente invention est précisément celui de permettre une généralisation d'application des cartes sous enveloppe dans toutes les utilisations possibles en donnant à ces cartes une commodité d'emploi et une fiabilité particulièrement élevées.

A cet effet, l'invention a notamment pour objet un connecteur électrique, en particulier d'un module comportant au moins un circuit électrique ou électronique destiné à être relié, par une première pluralité de pistes conductrices, à une seconde pluralité de pistes conductrices appartenant à un système électrique auquel doit être associé le module, caractérisé par le fait qu'au moins l'extrémité de contact des pistes conductrices de la première pluralité de pistes est solidaire d'un substrat formé d'une feuille isolante souple sur laquelle est fixé ledit circuit intégré, que des moyens élastiques maintiennent ce substrat dans une première position stable dans laquelle, lorsque le module est positionné par rapport au système de manière que les pistes conductrices de chaque pluralité de pistes se font face, les pistes associées au substrat demeurent distantes de celles du système, ces moyens ramenant ce substrat dans ladite première position lorsqu'il en est écarté, et caractérisé par le fait que le module comporte un mobile susceptible d'être conduit successivement dans deux positions limites de sa trajectoire, ce mobile étant cinématiquement solidaire d'au moins un poussoir susceptible de faire prise sur ladite feuille isolante et d'en commander un fléchissement, à l'encontre de l'action desdits moyens élastiques, qui soit suffisant pour porter en contact galvanique chaque piste conductrice associée à cette feuille avec une piste déterminée parmi celles appartenant audit système électrique au moins lorsque le mobile atteint un point intermédiaire de ladite trajectoire, dans son mouvement en direction de l'un desdits points limites et pendant tout son déplacement entre ledit point intermédiaire et ce point limite.

L'invention concerne également une seconde forme d'exécution d'un tel connecteur électrique, mettant en oeuvre une inversion cinématique du connecteur électrique défini précédemment.

A cet effet, l'invention a, de plus, pour objet un connecteur électrique qui est, comme le précédent, destiné à relier, par une première pluralité de pistes conductrices, le circuit électrique ou électronique que comporte un module donné, à une seconde pluralité de pistes conductrices appartenant à un système électrique auquel doit être associé le module, ce connecteur étant caractérisé par le fait qu'au moins l'extrémité de contact des pistes conductrices de la première pluralité de pistes est solidaire d'un substrat formé d'une feuille isolante souple sur laquelle est fixé ledit circuit intégré, que des moyens élastiques maintiennent ce substrat dans une première position stable dans laquelle, lorsque le module est positionné par rapport au système de manière que les pistes conductrices de chaque pluralité de pistes se font face, les pistes associées au substrat sont en contact galvanique avec celles du système, ces moyens ramenant ce substrat dans ladite première position lorsqu'il en est écarté, et par le fait que le module comporte un mobile susceptible d'être conduit successivement dans deux positions limites de sa trajectoire, ce mobile étant cinématiquement solidaire d'au moins un poussoir susceptible de faire prise sur ladite feuille isolante et d'en commander un fléchissement, à l'encontre de l'action desdits moyens élastiques, qui soit suffisant pour écarter chaque piste conductrice associée à cette feuille de la piste respective appartenant audit système électrique au moins lorsque le mobile atteint un point intermédiaire de ladite trajectoire, dans son mouvement en direction de l'un desdits points limites et pendant tout son déplacement entre ledit point intermédiaire et ce point limite.

D'autres caractéristiques et avantages de la présente invention apparaitront de la description qui va suivre, laquelle fait référence aux dessins annexés:

La fig. 1 est une vue montrant, en plan, un module muni du connecteur selon l'invention fixé sur un appareil électronique partiellement représenté.

La fig. 2 est une vue en plan et à plus grande échelle d'un détail constructif de cet appareil.

La fig. 3 est une vue en coupe partielle selon l'axe III-III de la fig. 1.

La fig. 4 est une vue selon IV-IV de la fig. 3, avec arrachement partiel.

La fig. 5 est une vue en coupe selon V-V de la fig. 1, dans une autre position de certains éléments.

La fig. 6 est une vue éclatée et en perspective d'une partie de la carte apparaissant sur la fig. 1.

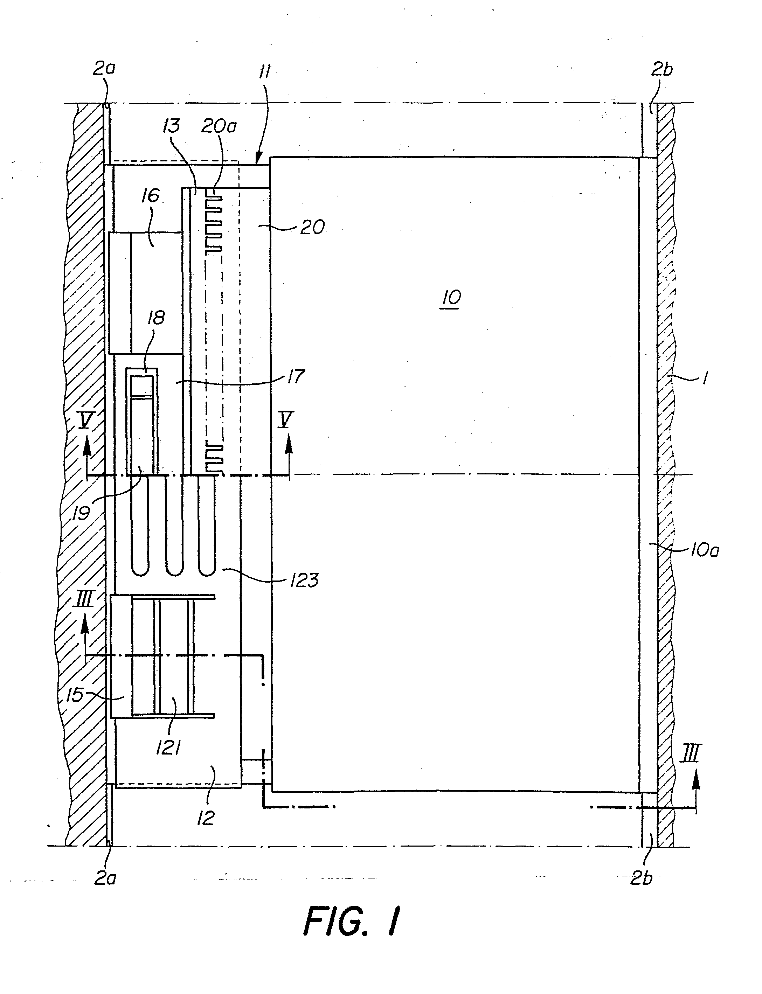

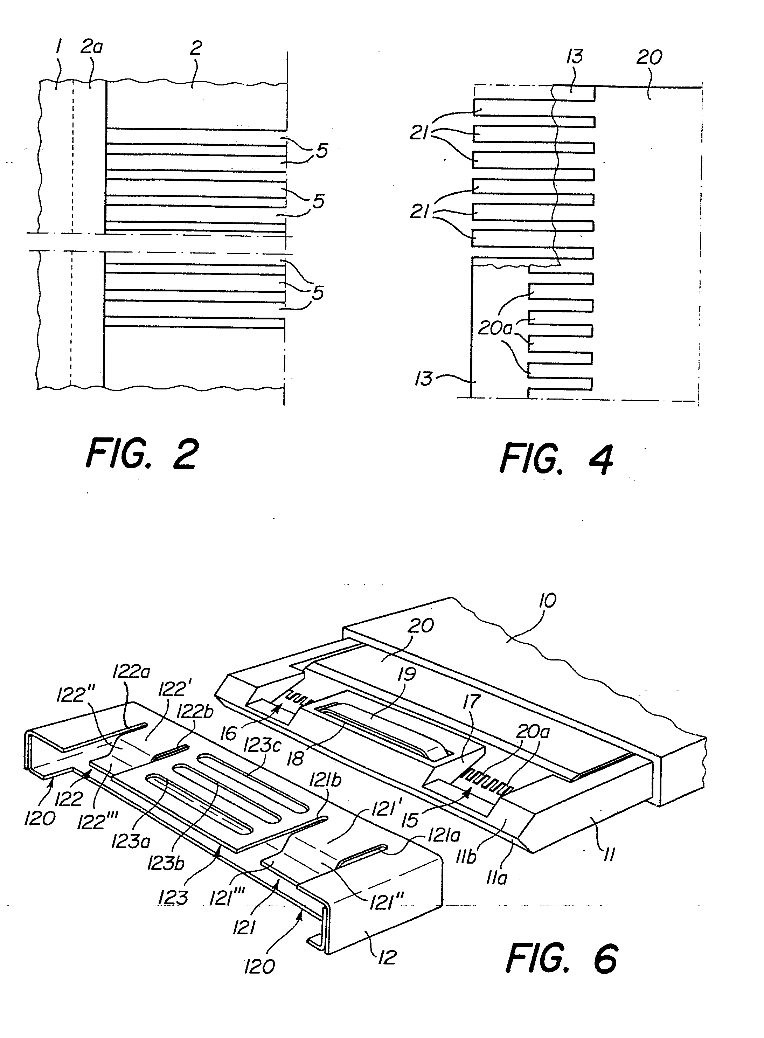

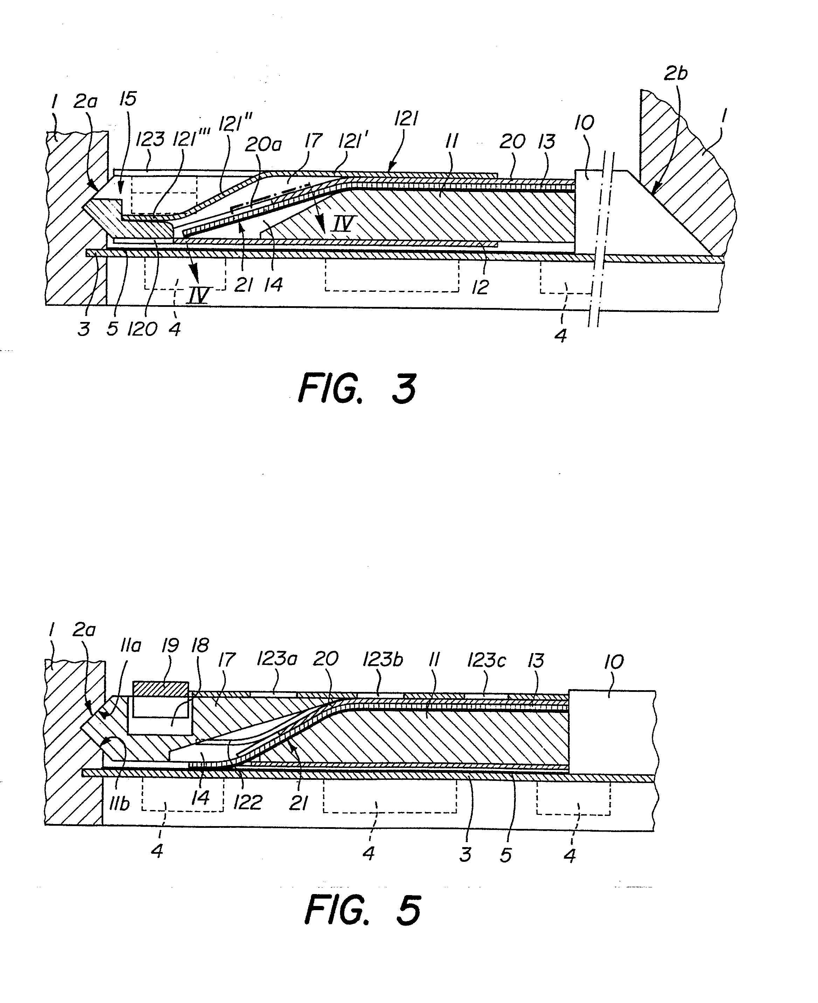

Au dessin (fig. 1), 1 représente une portion du boîtier d'un appareil électronique, par exemple un petit ordinateur, qui est creusé par une rainure 2 dont les parois longitudinales sont à leur tour entaillées par des gorges de section triangulaire, 2a et 2b (figs 2 et 3), s'étendant sur toute la longueur de la rainure 2, rainure dont le fond 2c est formé par le revers d'une plaque isolante 3 constituant un circuit imprimé sur l'avers duquel sont fixés de manière traditionnelle des "chips" tels que 4, cette plaque constituant ainsi ce qui est traditionnellement appelé un "p.c. board" ou "printed circuit board". Ce circuit imprimé et les chips intégrés qu'il porte peuvent former toutes sortes de circuits nécessaires au fonctionnement d'un ordinateur: ne faisant pas partie de l'invention, cet ensemble structurel ne sera pas décrit dans le détail.

Disons simplement que, dans le cas d'espèce, la partie visible du "p.c. board" 3 est plus particulièrement celle qui, selon une caractéristique essentielle et très avantageuse de l'invention, est destinée à permettre le branchement électrique sur l'ordinateur de circuits électroniques amovibles pouvant constituer tous genres d'éléments de logiciels d'appoint tels que mémoires d'extension ou de complément des RAM et ROM de base de l'ordinateur, mémoires de stockage, programmes particuliers de toute nature, etc... Ainsi qu'on le verra de façon plus détaillée par la suite, le branchement est destiné à être effectué par l'intermédiaire d'une pluralité de barres "bus" qui se présentent sous forme d'une pluralité de pistes conductrices 5, s'étendant parallèlement sur le revers de la plaque 3, soit au dessin sur la face supérieure de celle-ci (figs 2 et 3). Ces pistes peuvent être obtenues de toutes manières, selon les techniques connues de fabrication des circuits imprimés. En l'espèce, ces pistes peuvent présenter une largeur de l'ordre de 8/10 de mm avec un écartement de 4/10 de mm et s'étendent, par groupe d'une quarantaine, du bord de la rainure 2 muni de la gorge 2a vers l'autre bord de cette rainure, sur une longueur de 1 à 2 centimètres ou même sur toute la largeur de la rainure, selon les cas.

La rainure 2 du boîtier 1 est en effet destinée à recevoir un ou plusieurs modules englobant précisément les éléments de logiciel ci-dessus et dont l'architecture générale de même que leurs particularités structurelles essentielles vont maintenant être décrites. Un tel module est formé par assemblage de trois parties principales, à savoir un boîtier 10, un embout de connection 11 et un coulisseau 12 permettant d'agir sur l'embout 11 en vue de relier galvaniquement les circuits du module aux barres "bus" 5 déjà citées, ou d'interrompre cette liaison. Le coulisseau 12 peut également commander le verrouillage mécanique du module correspondant dans la rainure 2, dans une position relative appropriée au transfert des informations du module et vers le module par l'intermédiaire des barres bus 5.

Comme on le voit au dessin, le boîtier 10 est formé par une sorte de pochette au fond 10a de section droite triangulaire (figs 1 et 3) par lequel le module peut être inséré et glissé longitudinalement dans la gorge 2b de la rainure 2 de l'appareil. Ce boîtier peut être réalisé en acier inoxydable ou en matière plastique dure. Il contient, en substance, l'ensemble des "chips" concernés par la fonction attribuée au module, montés de façon traditionnelle sur un circuit imprimé constituant le p.c. board du module et qui est formé, par toute technique connue, sur une feuille en matière synthétique souple, par exemple en résine époxy, dont la partie extrême gauche 13 fait saillie hors du boîtier 10 pour constituer l'un des éléments essentiels de l'embout de connection 11 (fig. 3).

Dans la forme d'exécution représentée, les faces latérales, la face supérieure et la face inférieure du boîtier 10 sont planes et parallèles deux à deux. A titre d'exemple, on signalera qu'un tel boîtier peut présenter une épaisseur de 2 à 3 millimètres, ce qui est exceptionnellement peu pour ce genre d'article.

L'embout de connection 11 se présente sous la forme d'une plaquette en matière plastique insérée à force, par son extrémité droite au dessin, dans l'ouverture du boîtier 10 et dont l'extrémité gauche présente deux biseaux 11a et 11b formant un dièdre par lequel l'embout 11 est inséré dans la gorge 2a ménagée dans la face gauche de la rainure 2 du boîtier 1 de l'appareil.

Comme on le voit au dessin (figs 3 et 4), la plaquette formant l'embout 11 est traversée par un passage 14, s'ouvrant tant sur la face supérieure que sur la face inférieure de la plaquette et dont la largeur croît au fur et à mesure qu'on s'éloigne de la première pour aller vers la seconde. On remarquera encore que le passage 14 part environ à mi-longueur de la face supérieure de la plaquette pour aboutir à proximité de l'extrémité gauche de la face inférieure de celle-ci.

La partie de l'embout comprise entre ce passage 14 et son extrémité est taillée par deux découpures 15 et 16 délimitant une sorte de bec central 17 présentant un logement 18, de forme générale parallélépipédique, dans lequel est disposé un ressort "lyre" 19, tendant à faire naturellement saillie lorsqu'il est dégagé (fig. 5) et qu'il est possible d'escamoter tout entier dans le logement 18 par simple pression du doigt sur sa partie supérieure.

Le fond des découpures 15 et 16 présente un profil en "escalier" à deux gradins, s'étendant jusqu'à la face inférieure de l'embout 11. Le gradin supérieur constitue un organe de butée destiné à fixer l'une des positions limites susceptibles d'être occupées par le coulisseau 12, ainsi que cela sera décrit par la suite.

Comme cela est visible sur cette figure, la feuille isolante 13, constituant le p.c. board du module représenté, est maintenue au contact de la portion de l'embout 11 formant le bec 17 et qui est située à gauche du passage 14. Cette feuille traverse ce passage pratiquement sur toute sa longueur jusqu'à proximité de la face inférieure de l'embout 11.

En effet, sur la plus grande partie de sa longueur faisant saillie du boîtier 10, cette feuille 13 est protégée par une sorte de carapace, constituée par une tôle mince 20, en acier inoxydable, fixée à même la feuille, par exemple par collage, et dont l'extrémité libre, qui est en retrait par rapport à l'extrémité homologue de la feuille 13, est découpée de manière à former une série de dents 20a (fig. 4). Par cette dentelure, la carapace 20 est localement affaiblie de manière à lui donner une flexibilité accrue autorisant par là une déformation plus facile en flexion de la portion sousjacente de la feuille 13.

La tôle 20 a été préformée de manière à exercer la fonction d'un moyen élastique tendant à rappeler constamment la feuille 13 dans la position visible sur la fig. 3 si cette feuille en est écartée.

La largeur ainsi que l'écartement des dents 20a de la carapace revêtant la feuille 13 correspondent en tous points à la largeur et à l'écartement d'une pluralité de pistes conductrices 21 dont est garnie la face inférieure de cette feuille, ces pistes s'étendant jusqu'à l'intérieur du boîtier 10 et faisant partie du circuit imprimé de couplage des divers chips du circuit électronique disposé dans le boîtier. Dans leur partie comprise entre l'extrémité des dents 20a de la carapace 20 et leur propre extrémité libre, les pistes conductrices 21 sont revêtues de préférence d'une couche de contact d'un métal précieux, par exemple de l'or.

Comme on le verra par la suite, les pistes conductrices 21 sont en effet destinées à être portées en contact avec les pistes 5 apparaissant au fond de la rainure 2 du boîtier 1 de l'appareil électronique auquel doit être associé le module considéré: leur largeur et leur écartement seront donc identiques en valeur à la largeur et à l'écartement des pistes 5.

A titre de rappel, de telles pistes peuvent présenter une largeur de l'ordre de 8/10 de mm pour un écartement de l'ordre de 4/10 de mm. On pourra, au besoin, leur donner même des dimensions de valeur inférieure tout en étant assurés du maintien de leur qualité intrinsèque pendant une durée de temps de fonctionnement très importante.

En effet, et selon une particularité essentielle de l'invention, la liaison galvanique entre le circuit électronique du module formé des éléments 10, 11 et 12 et le circuit électronique porté par le p.c. board que constitue la plaque 3 est réalisée par contact direct entre les pistes conductrices 5 du circuit imprimé que porte cette plaque et les pistes conductrices 21 dont est munie la face inférieure de la feuille souple 13. Ainsi qu'on le verra ci-après, un tel contact est obtenu avec un frottement réduit entre les pistes ce qui assure évidemment une usure minimum et donc une excellente longévité des surfaces actives des pistes en présence.

C'est par actionnement manuel du coulisseau 12 que se réalisent tant la liaison galvanique des pistes conductrices 5 et 21 que l'interruption de cette liaison.

Un tel coulisseau se présente, en effet, sous la forme d'un fourreau de section droite rectangulaire (fig. 6), formé par assemblage de deux cornières en U, par exemple en acier inoxydable de 2 à 3/10 de mm d'épaisseur, dont l'ouverture est de section correspondant en substance à celle de l'embout 11. Ce fourreau est en effet engagé à coulissement sur cet embout et peut être conduit manuellement d'une première position limite, visible sur la fig. 3, dans une seconde position limite (fig. 5) et vice-versa.

La face inférieure du fourreau 12 est découpée par une entaille rectangulaire 12a (figs 3 et 6) s'étendant pratiquement sur toute la largeur du coulisseau, dont la profondeur est choisie telle que, dans la première position axiale limite du coulisseau (fig. 3), l'ouverture inférieure du passage 14 soit obturée par le coulisseau, alors que cette même ouverture est dégagée dans l'autre position limite.

Sur sa face supérieure, le coulisseau 12 comporte, de plus, deux paires de fentes parallèles 121a et 121b, respectivement 122a et 122b, d'écartement correspondant sensiblement à la largeur des découpures 15 et 16 déjà citées, délimitant ainsi trois pattes 121, 122 et 123 dont la dernière, 123, qui est de forme générale rectangulaire, est située très exactement au centre de la face supérieure du coulisseau 12, coaxialement à l'axe longitudinal de celui-ci. Trois fenêtres 123a, 123b et 123c pratiquées dans la patte 123 constituent autant d'évidements permettant à la partie charnue de l'extrémité des doigts de l'usager désirant actionner le coulisseau de faire facilement prise sur celui-ci.

Chacune des deux autres pattes 121 et 122 comporte trois parties essentielles, à savoir une première partie 121', respectivement 122', s'étendant dans le plan général de la face supérieure du coulisseau, par laquelle la patte correspondante demeure solidaire du reste de cette face, une deuxième partie 121", respectivement 122", inclinée vers la face inférieure du coulisseau et vers l'arrière de celui-ci, puis une troisième partie 121''', respectivement 122''' solidaire de la deuxième partie de la patte respective et s'étendant parallèlement aux deux faces inférieure et supérieure du coulisseau 12. Dans la zone de liaison des parties adjacentes 121', 121"; 121", 121''' - respectivement 122', 122"; 122", 122''' de chaque patte, ces pattes sont légèrement affaiblies par creusage d'une rainure très peu profonde pratiquée dans l'épaisseur de chaque patte. Ce faisant, il a été possible d'accroître la souplesse naturelle de telles pattes.

Comme on le voit sur la fig. 3, la longueur et l'inclinaison données à la partie intermédiaire 121", respectivement 122", de la patte 121, respectivement 122 sont choisies de façon que la face inférieure de la partie terminale 121''', respectivement 122''' de cette patte s'étende à un niveau légèrement supérieur au niveau du gradin inférieur du fond de la découpure 15, respectivement 16, apparaissant de part et d'autre du bec 17 de l'embout 11. De plus, on remarquera que, lorsque le coulisseau occupe la position visible sur la fig. 3, les pattes 121 et 122 empêchent de désenfiler ce coulisseau de l'embout 11, par déplacement subséquent du coulisseau vers la gauche au dessin, parce qu'elles sont en appui sur le gradin supérieur du fond des découpures 15 et 16, gradins faisant ainsi office de butée. Dans cette même position du coulisseau, l'ouverture inférieure du passage 14 de l'embout 11 est obturée par la face inférieure du coulisseau, alors que celui-ci recouvre entièrement la face supérieure du bec 17 par sa patte 123, celle-ci maintenant le ressort-lyre 19 en position escamotée dans le logement 18. Enfin, on voit que les deux pattes 121 et 122 occupent une position distante de la portion de l'ensemble composite formé par la feuille souple 13, les pistes conductrices qu'elle porte sur sa face inférieure et la carapace 20 qui la recouvre, portion qui traverse pratiquement de part en part le passage 14 et qui appuie librement sur le bec 17 de l'embout 11 ainsi que décrit précédemment.

Si on déplace le coulisseau ou fourreau 12 de gauche à droite du dessin, en vue de l'éloigner de sa première position limite représentée sur la fig. 3, alors les pattes 121 et 122 tendront à se rapprocher de plus en plus de la partie de l'ensemble composite, ci-dessus en appui élastique sur le bec 17 de l'embout 11, en même temps que la face inférieure du coulisseau masquera de moins en moins l'ouverture inférieure du passage 14.

Arrivera un moment où les pattes 121 et 122 viendront en contact avec la carapace 20 recouvrant la feuille souple 13 obligeant cette carapace, et la feuille 13 qui lui est solidaire, à fléchir vers le bas, à l'encontre de l'action élastique exercée par la carapace 20, de sorte que l'extrémité inférieure de la feuille 13 et des pistes conductrices 21 qui lui sont associées vont devoir sortir du passage 14 par son ouverture inférieure, au fur et à mesure du dégagement de cette ouverture par le coulisseau, dans son mouvement vers la droite au dessin.

Le coulisseau 12 continuant d'être déplacé et les pattes 121 et 122 de faire fléchir toujours plus la carapace 20 et la feuille 13 qui lui est associée, à un certain moment cette feuille et les pistes 21 viendront en contact avec la plaque 3 constituant le fond de la rainure 2 dans laquelle est inséré le module représenté et avec les pistes 5 que porte la face supérieure de cette plaquette. Dès cet instant, la partie de la feuille souple 3 située en aval des dents 20a de la carapace 20 va fléchir de plus en plus en amenant une longueur des pistes 21 de plus en plus importante en contact avec une longueur correspondante des pistes 5.

Il convient à ce point de signaler que les pattes 121 et 122 exercent alors sur la feuille 13 une force de l'ordre de 1 ou 2 kg par patte.

La position limite droite susceptible d'être occupée par le coulisseau 12 est celle représentée sur la fig. 5. On voit que ce coulisseau est bloqué dans cette position par appui, à gauche, sur le ressort-lyre 19, qui fait partiellement saillie hors de son logement 18, dont l'ouverture est maintenant toute dégagée, et, à droite, sur le boîtier 10 du module.

On remarque, en outre, que l'ouverture inférieure du passage 14 est alors entièrement dégagée par le coulisseau, livrant un passage suffisant pour la feuille souple 13 et ses pistes conductrices, et que cette feuille est prise en sandwich entre les pattes 121 et 122 du coulisseau et la paroi droite du passage 14 contre laquelle elle prend appui.

Pour ramener le coulisseau de sa position extrême droite (fig. 5) dans la position limite de gauche (fig. 3), on exercera d'abord une pression sur le ressort-lyre 19 qui soit suffisante pour le faire s'escamoter à l'intérieur du logement 18, puis on tirera ce coulisseau vers la gauche, par exemple en faisant prise des doigts sur la patte 123 du coulisseau. Ce faisant, les pattes 121 et 122 relâcheront leur action sur la carapace 20 laquelle tendra à ramener élastiquement la feuille 13 vers sa position de repos représentée sur la fig. 3, le déplacement angulaire de cette feuille ayant pour conséquence un éloignement graduel des pistes conductrices 21 par rapport aux pistes 5, puis une séparation de celles-ci et, donc l'interruption de toute liaison électrique entre le p.c. board de l'appareil 1 et le p.c. board du module encore engagé dans la rainure 2.

La mise en contact mutuel des pistes 5 et 21 de même que leur séparation s'est donc effectuée de façon particulièrement douce, sans grand frottement, seul un léger rampement des pistes 21 ayant lieu en cours d'opération. Il s'ensuit que de telles opérations de commutation s'effectuent avec une usure minime des surfaces en présence, assurant une grande longévité des pistes qu'il s'agisse des pistes 5 ou des pistes 21. C'est ainsi que, à l'essai, il a été possible de réaliser plusieurs milliers de commutations sans observer d'usure notable.

Dans une variante d'exécution, non représentée, le module décrit pourrait présenter une ou plusieurs pattes de verrouillage faisant saillie par exemple sur les faces latérales du coulisseau et destinées à être portées en prise avec des fentes correspondantes ménagées au fond de la rainure de l'appareil dans laquelle le module est destiné à être glissé, ces pattes ne pénétrant dans ces fentes qu'à partir d'une certaine position axiale du coulisseau atteinte au cours de son déplacement de la position limite de la fig. 3 vers la position limite de la fig. 5. Le déverrouillage aurait lieu à partir de cette même position axiale lors d'un déplacement de direction inverse du coulisseau.

Dans une deuxième variante d'exécution, également non représentée, le module décrit pourrait être muni d'un interrupteur logé dans l'embout 11 et susceptible de relier les pistes du p.c. board du circuit électronique de ce module aux "chips" du circuit seulement lorsque le coulisseau occupe la position limite de la fig. 5, le coulisseau commandant cet interrupteur à l'instant approprié. Ce faisant, il sera donc possible d'obtenir que les pistes conductrices du module ne soient parcourues par aucun courant tant que le contact avec les pistes de l'appareil auquel le module est destiné ne sera pas parfait. En outre, pour des modules englobant une pile d'alimentation des chips de son circuit électronique, ce qui est par exemple le cas lorsqu'un tel circuit constitue une mémoire vive, on évitera que les pistes de tels modules soient sous tension tant que ces modules n'auront pas été portés en position active. Dans une telle éventualité, il sera évidemment possible d'utiliser l'interrupteur pour contrôler directement l'alimentation du circuit électronique à partir de la pile.

Dans une deuxième forme d'exécution de l'invention, il serait possible de constituer un module formant en quelque sorte une inversion cinématique du module décrit en se référant aux figs 1 à 5. En
effet, alors que dans la construction représentée sur ces figures
il a été fait emploi d'une carapace 20 préformée de manière à jouer
le rôle d'un moyen élastique tendant à maintenir la feuille 13 et
ses pistes conductrices 21 dans une position la plus enfoncée possible à l'intérieur du passage 14 traversant l'embout 11, les pattes 121 et 122 ayant pour tâche d'écarter cette feuille 13 de cette position enfoncée pour la faire saillir au travers de l'ouverture inférieure du passage 14, il serait possible de préformer la carapace 20 de manière que, par son élasticité, elle tende au contraire à pousser la feuille 13 et les pistes conductrices 21 en vue d'en
faire saillir naturellement l'extrémité de contact au travers de l'ouverture inférieure du passage 14. Dans un tel cas, le rôle des pattes 121 et 122 serait alors l'inverse du précédent, ces pattes devant empêcher la feuille 13 de suivre le mouvement imposé par le moyen élastique que constituerait la carapace 20 tant que les pistes
conductrices associées à cette feuille doivent demeurer distantes
de celles constituant les barres "bus" de l'appareil sur lequel serait fixé le module.

Dans son architecture présente, telle que décrite en se référant aux dessins annexés, le module selon l'invention offre un certain nombre d'avantages qui le rendent particulièrement facile à fabriquer et à utiliser.

On notera par exemple que, dans un tel module, le moyen élastique de rappel constitué par la carapace 20 n'assure que cette fonction de sorte qu'il n'est traversé par aucun courant ce qui permet
de réaliser cette carapace en un matériau bon marché, ne présentant
pas de caractéristiques électriques particulières. Dans le cas d'espèce, il a par exemple été fait emploi de tôle inox de qualité courante.

En outre, lorsque le module n'est pas en position active (telle celle de la fig. 5) par exemple parce que non utilisé et entreposé à distance du système électrique auquel il est destiné à être
associé, les pistes conductrices que porte la feuille souple 13 sont
entièrement protégées, à l'abri de toute souillure possible ou de
tout contact susceptible de les détériorer, les éléments du module occupant alors la position de la fig. 3, dans laquelle le coulisseau 12 obture les deux ouvertures d'extrémité du passage 14 de l'embout 11.

On remarquera encore que, malgré l'épaisseur très réduite du module (2 à 3 mm), la course de la portion extrême de la feuille 13 est relativement importante et est de l'ordre de l'épaisseur de l'ensemble formé par cette feuille et par la carapace 20.

Enfin, bien que dans la description et dans les dessins on n'ait envisagé que le cas où les pistes conductrices 5 s'étendent transversalement à l'axe longitudinal de la rainure 2, il est évident que ces pistes pourraient, en variante, être disposées parallèlement à un tel axe.

Dans ce cas, ce seraient naturellement les faces latérales du module, actuellement planes, qui devraient être profilées, l'une, comme l'extrémité 11a, 11b de l'embout 11 et, l'autre, comme l'extrémité 10a du boîtier 10 du module, les autres éléments structurels d'un tel module demeurant inchangés.

Cette variante offre un avantage certain par rapport à ce qui a été décrit jusqu'ici: c'est ainsi qu'il sera alors possible de disposer en file, dans la rainure 2, une pluralité de modules de longueur identique ou de longueur différente, adaptée à la nature et aux nécessités particulières d'un tel module. En outre, dans cette variante, un seul jeu de barres "bus" suffit pour tous les modules introduits dans la rainure 2: dans l'exécution décrite, chaque module devait être branché sur un jeu de barres "bus" propre, de sorte qu'il fallait prévoir, a priori, autant de jeux de barres "bus" distincts que de modules à insérer côte-à-côte dans la rainure 2.

Dans une dernière variante, également non représentée, les pattes 121 et 122 pourraient être non pas venues de fabrication par étampage du coulisseau, mais être constituées par des tiges filetées se vissant dans des écrous fixés au coulisseau, dont l'extrémité libre viendrait en contact avec la carapace 20 au cours du déplacement de ce coulisseau, comme dans le cas des pattes 121 et 122. Cette variante permettrait d'obtenir un réglage calibré de la pression exercée sur cette carapace, et donc sur les pistes conductrices en contact avec les barres "bus" du système auquel doit être relié le module considéré, la variation de pression pouvant être obtenue par vissage plus ou moins prononcé des tiges dans les écrous.

On remarquera enfin que, grâce à l'architecture proposée, dans quelque variante que ce soit, un module peut être mis en place dans la rainure sans devoir exercer un grand effort et que, lors de cette insertion, les pistes conductrices qu'il comporte ne risquent pas d'être arrachées, celles-ci étant escamotées à l'intérieur de l'embout 11 du module et étant de surcroit protégées par le coulisseau en position d'obturation du passage 14.

# REVENDICATIONS

1. Connecteur électrique, en particulier d'un module comportant au moins un circuit électrique ou électronique destiné à être relié, par une première pluralité de pistes conductrices, à une seconde pluralité de pistes conductrices appartenant à un système électrique auquel doit être associé le module, caractérisé par le fait qu'au moins l'extrémité de contact des pistes conductrices de la première pluralité de pistes est solidaire d'un substrat formé d'une feuille isolante souple sur laquelle est fixé ledit circuit intégré,

que des moyens élastiques maintiennent ce substrat dans une première position stable dans laquelle, lorsque le module est positionné par rapport au système de manière que les pistes conductrices de chaque pluralité de pistes se font face, les pistes associées au substrat demeurent distantes de celles du système, ces moyens ramenant ce substrat dans ladite première position lorsqu'il en est écarté,

et par le fait que le module comporte un mobile susceptible d'être conduit successivement dans deux positions limites de sa trajectoire, ce mobile étant cinématiquement solidaire d'au moins un poussoir susceptible de faire prise sur ladite feuille isolante et d'en commander un fléchissement, à l'encontre de l'action desdits moyens élastiques, qui soit suffisant pour porter en contact galvanique chaque piste conductrice associée à cette feuille avec une piste déterminée parmi celles appartenant audit système électrique au moins lorsque le mobile atteint un point intermédiaire de ladite trajectoire, dans son mouvement en direction de l'un desdits points limites et pendant tout son déplacement entre ledit point intermédiaire et ce point limite.

2. Connecteur électrique, en particulier d'un module comportant au moins un circuit électrique ou électronique destiné à être relié, par une première pluralité de pistes conductrices, à une seconde pluralité de pistes conductrices appartenant à un système électrique auquel doit être associé le module, caractérisé par le fait qu'au moins l'extrémité de contact des pistes conductrices de la première pluralité de pistes est solidaire d'un substrat formé d'une feuille isolante souple sur laquelle est fixé ledit circuit intégré,

que des moyens élastiques maintiennent ce substrat dans une première position stable dans laquelle, lorsque le module est positionné par rapport au système de manière que les pistes conductrices de chaque pluralité de pistes se font face, les pistes associées au substrat sont en contact galvanique avec celles du système, ces moyens ramenant ce substrat dans ladite première position lorsqu'il en est écarté,

et caractérisé par le fait que le module comporte un mobile susceptible d'être conduit successivement dans deux positions limites de sa trajectoire, ce mobile étant cinématiquement solidaire d'au moins un poussoir susceptible de faire prise sur ladite feuille isolante et d'en commander un fléchissement, à l'encontre de l'action desdits moyens élastiques, qui soit suffisant pour écarter chaque piste conductrice associée à cette feuille de la piste respective appartenant audit système électrique au moins lorsque le mobile atteint un point intermédiaire de ladite trajectoire, dans son mouvement en direction de l'un desdits points limites et pendant tout son déplacement entre ledit point intermédiaire et ce point limite.

FIG. 1

0154602

FIG. 2

FIG. 4

FIG. 6

0154602

FIG. 3

FIG. 5

# Office européen des brevets

## RAPPORT DE RECHERCHE EUROPEENNE

EP  85 81 0014

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl 4) |
|---|---|---|---|
| P,X | EP-A-0 121 467  (COMMISSARIAT A L'ENERGIE ATOMIQUE) <br> * Page 5, ligne 8 - page 12, ligne 28; figures 1-4 * | 1,2 | H 01 R   23/68 |
| | --- | | |
| Y | EP-A-0 006 725  (AMP) <br> * Résumé; figures * | 1,2 | |
| | --- | | |
| Y | US-A-4 331 372  (AMP) <br> * Colonne 4, lignes 4-24; figures * | 1,2 | |
| | --- | | |
| A | US-A-3 082 398  (AMPHENOL-BORG) <br> * Figures * | 1,2 | |
| | --- | | |
| A | GB-A- 887 101  (ASSOCIATED ELECTRICAL IND.) <br> * En entier * | 1,2 | DOMAINES TECHNIQUES RECHERCHES (Int. Cl.4) <br><br> H 01 R |
| | --- | | |
| A | US-A-3 491 328  (AMP) <br> * Figures * | 1,2 | |
| | --- | | |
| A | US-A-4 080 027  (GTE SYLVANIA) <br> * Résumé; figures * | 1,2 | |
| | --- | | |
| A | US-A-3 430 186  (THOMAS & BETTS) <br> * Résumé et figures * | 1,2 | |
| | ----- | | |

Le présent rapport de recherche a été établi pour toutes les revendications

| Lieu de la recherche | Date d'achèvement de la recherche | Examinateur |
|---|---|---|
| LA HAYE | 12-04-1985 | RAMBOER P. |